# EUROPEAN PATENT APPLICATION

(11) **EP 4 167 347 A1**
(43) Date of publication of application: **19.04.2023**
(21) Application number: 21825767.3
(22) Date of filing: 08.06.2021
(51) Int. Cl.: H01M 10/613, H01M 10/625, H01M 10/6554, F28D 15/02, H01M 50/342

(54) **METAL-RESIN COMPLEX, COOLING DEVICE, METHOD FOR MANUFACTURING METAL-RESIN COMPLEX, AND SAFETY VALVE STRUCTURE**

(30) Priority: 15.06.2020 JP 2020103294
(71) Applicant: Mitsui Chemicals, Inc., Tokyo 105-7122 (JP)
(72) Inventor: KURIYAGAWA, Mizue, Sodegaura-shi, Chiba 299-0265 (JP); KIMURA, Kazuki, Sodegaura-shi, Chiba 299-0265 (JP)
(74) Representative: J A Kemp LLP
(86) International application number: PCT/JP2021/021757
(87) International publication number: WO 2021/256328

(57) **Abstract**

A metal-resin complex, comprising a space surrounded by a metal component and a resin component, the resin component comprising at least one fragile portion.

## Description

### [Technical Field]

The present invention relates to a metal-resin complex, a cooling device, a method for manufacturing a metal-resin complex, and a safety valve structure.

### [Background Art]

As a means for cooling an object that generates heat during operation, such as a CPU mounted on a computer or a secondary battery mounted on an electric vehicle (hereinafter, also referred to a heat-emitting body), various types of cooling devices using a liquid coolant such as water have been proposed. For example, a cooling device having a channel for a coolant to flow inside a casing made of a material with a high degree of radiation performance such as metal is known (for example, Japanese Patent Application Laid-Open (JP-A) No. 2015-210032).

### [Summary of the Invention]

### [Problem to be Solved by the Invention]

The cooling device described in JP-A No. 2015-210032 is made from metal components that are joined to each other by welding so as to withstand the inner pressure applied by the coolant flowing internally and to prevent leakage of the coolant.

Meanwhile, in conjunction with a recent trend toward diversification in the purposes of cooling devices, there is demand for increasingly complicated shapes, weight reduction or production cost reduction, of cooling devices. In order to meet such demands, one approach is to partly replace metal components configuring the cooling device with a resin.

However, replacing some of the metal components with a resin will lower the joining strength at interfaces of the components of a cooling device, and there is room for improvement as regards guaranteeing the safety thereof.

In view of the foregoing, the present invention aims to provide a metal-resin complex and a cooling device, which include a portion made of a metal and a portion made of a resin and exhibit a high level of safety.

Further, the present invention aims to provide a method for manufacturing the metal-resin complex and a safety valve structure.

### [Means for Solving the Problem]

The means for solving the problem includes the following embodiments.
<1> A metal-resin complex, comprising a space surrounded by a metal component and a resin component, the resin component comprising at least one fragile portion.
<2> The metal-resin complex according to <1>, wherein the metal component has a panel shape.
<3> The metal-resin complex according to <1> or <2>, wherein the fragile portion has a greater degree of stress concentration than a portion around the fragile portion.
<4> The metal-resin complex according to <1> or <2>, wherein the fragile portion has a lower strength than a portion around the fragile portion.
<5> The metal-resin complex according to any one of <1> to <4>, wherein a material of the fragile portion is identical with a material that forms a portion of the resin component other than the fragile portion.
<6> The metal-resin complex according to any one of <1> to <5>, wherein in the resin component, the fragile portion and a portion other than the fragile portion are fused together.
<7> The metal-resin complex according to any one of <1> to <6>, wherein in the resin component, the fragile portion has a smaller thickness than a portion other than the fragile portion.
<8> The metal-resin complex according to any one of <1> to <7>, wherein the metal component has a concave-convex structure at at least a portion of a surface of the metal component.
<9> The metal-resin complex according to <8>, wherein the resin component penetrates the concave-convex structure at the surface of the metal component.
<10> The metal-resin complex according to <8>, comprising an adhesive between the metal component and the resin component, the adhesive penetrating the concave-convex structure at the surface of the metal component.
<11> A cooling device, comprising the metal-resin complex according to any one of <1> to <10>, and a channel for a liquid to flow through that is disposed inside the space of the metal-resin complex.
<12> A method for manufacturing the metal-resin complex according to any one of <1> to <11>, wherein the resin component has a through hole that penetrates from an inside to an outside of the space, and the fragile portion is formed by fusing a resin that plugs the through hole with the resin component.
<13> A safety valve structure, comprising:
   a first resin component that configures at least a portion around a closed space;
   a through hole formed at the first resin component; and
   a second resin component that plugs the through hole,
   the second resin component being fused with the first resin component, and being openable in accordance with fluctuations in an inner pressure of the space.

### [Effect of the Invention]

According to the present invention, a metal-resin complex and a cooling device, which include a portion made of a metal and a portion made of a resin and exhibit a high level of safety.

Further, the present invention aims to provide a method for manufacturing the metal-resin complex and a safety valve structure.

### [Brief explanation of the Drawings]

Fig. 1 is a drawing schematically illustrating an exemplary configuration of a cooling device.
Fig. 2 is a drawing schematically illustrating an exemplary configuration of a safety valve structure.

### [Embodiments for Implementing the Invention]

In the present disclosure, a numerical range indicated using "to" includes the numerical values before and after "to" as a minimum value and a maximum value, respectively.

In numerical ranges stated in a stepwise manner in the present disclosure, the upper limit value or the lower limit value stated in one numerical range may be replaced with the upper limit value or the lower limit value of another numerical range stated in a stepwise manner. Further, in the numerical range stated in the present disclosure, the upper limit value or the lower limit value of the numerical range may be replaced with the value shown in the examples.

In the present disclosure, each component may contain a plurality of substances corresponding thereto. When a plurality of substances corresponding to each component is present in the composition, the content of each component refers to the total content of the plurality of substances present in the composition, unless otherwise specified.

### <Metal-resin complex>

The metal-resin complex according to the present invention is a metal-resin complex comprising, comprising a space surrounded by a metal component and a resin component, the resin component comprising at least one fragile portion.

In the present disclosure, the "fragile portion" disposed at the resin component refers to a portion that is openable by brakeage, separation or the like, when an inner pressure in a space surrounded by the metal component and the resin component exceeds a predetermined level. Specifically, the fragile portion may be a portion having a greater degree of stress concentration than a portion around the fragile portion, a portion having a lower degree of strength than a portion around the fragile portion, or the like.

Examples of a state that the fragile portion has a lower degree of strength than a portion around the fragile portion include a state in which the fragile portion is breakable due to a low degree of strength of the fragile portion in itself; and a state in which the fragile portion is separable from a portion around the fragile portion due to a low degree of strength at a portion at which the fragile portion and the portion around the fragile portion are joined together.

The metal-resin complex has a metal component and a resin component. Therefore, the metal-resin complex is more adaptable to demand for increasingly complicated shape, reduced weight, reduced production cost and the like, as compared with a configuration being made of metal in its entirety.

Further, the metal-resin complex has at least one fragile portion at the resin component. Therefore, it is possible to reduce an inner pressure of the space of the metal-resin complex, which has been increased for some reason, by opening the fragile portion prior to causing breakage of other portions. As a result, it is possible to minimize the occurrence of accidents such as breakage or separation of components of the metal-resin complex, short-circuit of components nearby the metal-resin complex, or scattering of a content inside the space of the metal-resin complex.

The state of the fragile portion being opened is not particularly limited, as long as an inner pressure of a space surrounded by the metal component and the resin component can be reduced, and may be an embodiment in which the fragile portion breaks in itself; an embodiment in which the fragile portion does not break but separates from the resin component around the fragile portion; and the like.

Examples of the specific configuration of the fragile portion in the resin component includes a configuration in which the fragile portion is fused with a portion other than the fragile portion; and a configuration in which the fragile portion has a smaller thickness than a portion other than the fragile portion.

The fragile portion provided at the resin component may be the same component as the resin component around the fragile portion, or may be a different component from the resin component around the fragile portion. From the viewpoint of simplifying the production process of the fragile portion, the fragile portion is preferably the same component as the resin component around the fragile portion.

Exemplary cases in which the fragile portion is the same component as the resin component around the fragile portion include a case in which the fragile portion has a smaller thickness than the resin component around the fragile portion.

Exemplary cases in which the fragile portion is a different component from the resin component around the fragile portion include a case in which the fragile portion is a component that plugs a through hole formed at the resin component and is fused with the resin component around the fragile portion.

When the fragile portion is a different component from the resin component around the fragile portion, the material for the component as the fragile portion may be the same or different from the material for the resin component around the fragile portion. Further, the material for the component as the fragile portion may be a material other than a resin.

In a case in which a component as the fragile portion is fused with the resin component around the fragile portion, the material for the component as the fragile portion is preferably the same as the material for the resin component around the fragile portion.

When the fragile portion is a different component from the resin component around the fragile portion, the means for joining the fragile portion to the resin component around the fragile portion is not particularly limited. For example, the fragile portion may be joined to the resin component around the fragile portion by means of welding, or with adhesives, screws, clicks or the like.

The number and the position of the fragile portion in the metal-resin complex are not particularly limited, and may be selected depending on the purpose of the metal-resin complex. In view of the possibility of causing the leakage of a content inside the space from the fragile portion in an opened state, the fragile portion is preferably disposed at a position apart from an object that is disposed outside the metal-resin complex (for example, a heat-emitting body).

### (Shape of metal-resin complex)

The shape of the metal-resin complex is not particularly limited, and may be selected depending on the purpose or the like of the metal-resin complex.

When the metal-resin complex is used as a cooling device for a heat-emitting body, from the viewpoint of cooling performance, the metal-resin complex preferably has a shape that provides an enough area to contact the heat-emitting body. For example, the metal-resin complex may have a shape having a pair of principal planes (planes with the largest area) facing each other and a side plane that has an enough thickness to allow a fluid to flow though a space inside the metal-resin complex (for example, a plate shape). In that case, at least a portion at which the metal-resin complex contacts the heat-emitting body is preferably a metal component in view of the cooling performance.

When the metal-resin complex is in a shape having two principal planes facing each other, the shape of the principal planes are not particularly limited, and may be rectangular, round or other shapes. The area of the principal plane is not particularly limited, and may be selected depending on the purpose or the like of the metal-resin complex. For example, the area of the principal plane may be in a range of from 50 cm² to 5,000 cm². The thickness of the metal-resin complex may be in a range of from 1 mm to 50 mm.

From the viewpoint of facilitating the reduction of an inner pressure inside a space by opening the fragile portion, the resin component preferably has a panel shape. The resin component may have a concave-convex structure or the like at a surface thereof, in addition to the fragile portion. For example, the resin component may have a concave-convex structure that corresponds to a channel disposed at a space inside the metal-resin complex as described later.

The metal component and the resin component configuring the metal-resin complex may be in direct contact with each other, or an adhesive may exist between the metal component and the resin component.

### (Metal component)

The material for the metal component is not particularly limited, and may be selected depending on the purpose of the metal-resin complex, or the like.

Specific examples of the material for the metal component include iron, copper, nickel, gold, silver, platinum, cobalt, zinc, lead, tin, titanium, chromium, aluminum, magnesium, manganese, and alloys containing these metals (such as stainless steel, brass and bronze).

From the viewpoint of thermal conductivity, the metal is preferably aluminum, aluminum alloy, magnesium, magnesium alloy, copper and copper alloy, more preferably copper and copper alloy.

From the viewpoint of reducing the weight and securing the strength, the metal is preferably aluminum, aluminum alloy, magnesium and magnesium alloy.

The metal component preferably has a concave-convex structure, more preferably a concave-convex structure formed by surface treatment, at a surface of at least a portion to contact the resin component.

When the metal component has a concave-convex structure at a surface, for example, melted resin as the material for the resin component penetrates a concave-convex structure at a surface of the metal component, thereby improving the joining strength. Alternatively, when an adhesive is used to join the metal component and the resin component, the adhesive penetrates a concave-convex structure at a surface of the metal component, thereby improving the joining strength.

The method for performing the surface treatment to the metal component is not particularly limited, and may be selected from the known methods.

Examples of the method include a method using laser light as described in Japanese Patent No. 4020957; a method of immersing a surface of the metal component in an aqueous solution of an inorganic base such as NaOH or an inorganic acid such as HCl or HNO₃; a method of subjecting a surface of the metal component to anodization as described in Japanese Patent No. 4541153; a substitution crystallization method in which a surface of the metal component is etched with an aqueous solution including an acid-based etchant (preferably an inorganic acid, ferric ion or cupric ion) and optionally including manganese ions, aluminum chloride hexahydrate, sodium chloride or the like, as described in International Publication No. 2015/8847; a method of immersing a surface of the metal component in an aqueous solution of at least one selected from hydrazine hydrate, ammonia or a water-soluble amine compound (hereinafter, also referred to as an NMT method), as described in International Publication No. 2009/31632; a method of treating a surface of the metal component with a warm water, as described in JP-A No. 2008-162115; and a blast treatment.

It is possible to select a method for roughening depending on the material for the metal component, desired specific surface roughness, and the like.

Among these methods, from the viewpoint of securing the joining strength with the resin component or an adhesive, a treatment with an acid-based etchant is preferred.

Specific examples of the treatment with an acid-based etchant include a method in which the following processes (1) to (4) are performed in this order.

### (1) Pre-treatment

In order to remove a film formed of an oxide, a hydroxide or the like from a surface of the metal component, the metal component is subjected to pre-treatment. The pre-treatment is generally performed by mechanical polishing or chemical polishing. When the metal component is significantly contaminated with machine oil or the like at a surface to be joined to the resin component, it is possible to perform a treatment with an alkali aqueous solution containing sodium hydroxide, potassium hydroxide or the like, or a treatment for defatting.

### (2) Treatment with zinc ion-containing alkali aqueous solution

The metal component after being subjected to the pretreatment is immersed in a zinc ion-containing alkali aqueous solution to form a zinc-containing film at a surface thereof. The Zn ion-containing alkali aqueous solution contains an alkali hydroxide (MOH or M(OH)₂) and zinc ions (Zn²⁺) at a mass ratio (MOH or M(OH)₂/ Zn²⁺) of from 1 to 100. The M in MOH refers to an alkali metal or an alkali earth metal.

### (3) Treatment with acid-based etchant

The metal component is treated with an acid-based etchant containing an acid and at least one of ferric ions or cupric ions. In this treatment, the zinc-containing film is dissolved, and a micron-scale concave-convex structure is formed on a surface of the metal component.

### (4) After-treatment

The metal component is cleansed, generally by performing water-washing and drying. The after-treatment may include ultrasonic washing for desmutting.

From the viewpoint of increasing the contact area between the metal component and the resin component, the surface treatment may be performed twice or more. For example, the metal component may be subjected to a process for forming a micron-scale concave-convex structure (base roughened surface) by performing the processes (1) to (4), and subsequently a process for forming a nano-scale concave-convex structure (fine roughened surface).

Examples of the method for forming a fine roughened surface after forming a base roughened surface to the metal component include a method of contacting the metal component with an oxidizable acidic aqueous solution. The oxidizable acidic aqueous solution contains metallic cations having a standard electrode potential E⁰ of greater than -0.2 and 0.8 or less, preferably greater than 0 and 0.5 or less.

The oxidizable acidic aqueous solution preferably does not contain metallic cations having a standard electrode potential E⁰ of -0.2 or less.

Examples of the metallic cations having a standard electrode potential E⁰ of greater than - 0.2 and 0.8 or less include Pb²⁺, Sn²⁺, Ag⁺, Hg²⁺ and Cu²⁺. Among these, Cu²⁺ is preferred in view of scarcity of the metal, and in view of safety or toxicity of a metal salt thereof.

Examples of the compound that generates Cu²⁺ include inorganic compounds such as copper hydroxide, copper(II) oxide, copper(II) chloride, copper(II) bromide, copper sulfate and copper nitrate. From the viewpoint of safety, toxicity and efficiency of formation of a dendritic layer, copper oxide is preferred.

The oxidizable acidic aqueous solution includes nitric acid or a mixture of nitric acid with any one of hydrochloric acid, hydrofluoric acid or sulfuric acid. It is also possible to use a percarboxylic acid aqueous solution such as peracetic acid or performic acid.

When nitric acid is used as the oxidizable acidic aqueous solution and copper(II) oxide is used as the compound that generates metallic cations, the concentration of nitric acid in the aqueous solution may be, for example, from 10% by mass to 40% by mass, preferably from 15% by mass to 38% by mass, more preferably from 20% by mass to 35% by mass. The concentration of coper ions in the aqueous solutions may be, for example, from 1% by mass to 15% by mass, preferably from 2% by mass to 12% by mass, more preferably from 2% by mass to 8% by mass.

The temperature at which the metal component having a base roughened surface with an oxidizable acidic aqueous solution is not particularly limited. From the viewpoint of completing the roughening at a reasonable pace while suppressing an exothermic reaction, the temperature may be, for example, from ordinary temperature to 60°C, preferably from 30°C to 50°C. The time for the treatment may be, for example, from 1 minute to 15 minutes, preferably from 2 minutes to 10 minutes.

The state of the concave-convex structure formed at a surface of the metal component is not particularly limited, as long as the metal component exhibits a sufficient degree of joining strength with the resin component.

The average diameter of the concave portions in the concave-convex structure may be, for example, from 5 nm to 250 µm, preferably from 10 nm to 150 µm, more preferably from 15 nm to 100 µm.

The average depth of the concave portions in the concave-convex structure may be, for example, from 5 nm to 250 µm, preferably from 10 nm to 150 µm, more preferably from 15 nm to 100 µm.

When at least one of the average diameter or the average depth of the concave portion in the concave-convex structure is within the above range, the metal component tends to be joined to the resin component more tightly.

The average diameter or the average depth of the concave portions in the concave-convex structure may be measured using an electron microscope or a laser microscope. Specifically, the average diameter and the average depth of the concave portions may be given as an arithmetic average value of the values measured at arbitrarily selected 50 concave portions that are shown in micrographs of a surface and a cross-section of a surface of the metal component.

As necessary, the metal component may have a plated layer. The plated layer imparts various functions to the metal component, such as electrical conductivity, weldability or anticorrosivity. For example, a plated layer that imparts electrical conductivity to the metal component has an effect of suppressing the occurrence of contact resistance, which is caused by formation of an insulating film at a surface of the metal component. The material for the plated layer is not particularly limited, and may be selected from known materials such as tin (Sn), zinc (Zi), nickel (Ni) and chromium (Cr). The thickness of the plated layer is not particularly limited, and may be selected from a range of 10 nm to 2,000 µm, for example.

When the metal component has a plated layer, the metal component may have a plated layer at the entirety of a surface thereof, or may have at a portion of a surface thereof.

From the viewpoint of suppressing the contact resistance, the metal component preferably has a plated layer at at least a portion that is not in contact with the resin component.

From the viewpoint of securing the joining strength with respect to the resin component, the metal component preferably does not have a plated layer at a portion that is in contact with the resin component.

### (Resin component)

The resin component used in the metal-resin complex includes a resin. The type of the resin is not particularly limited, and may be selected depending on the purpose or the like of the metal-resin complex.

Examples of the resin include thermoplastic resins such as polyolefin resin, polyvinyl chloride, polyvinylidene chloride, polystyrene resin, AS (acrylonitrile/styrene) resin, ABS (acrylonitrile/butadiene/styrene) resin, polyester resin, poly(meth)acrylic resin, polyvinyl alcohol, polycarbonate resin, polyamide resin, polyimide resin, polyether resin, polyacetal resin, fluorine resin, polysulfone resin, polyphenylene sulfide resin and polyketone resin;
thermosetting resins such as phenol resin, melamine resin, urea resin, polyurethane resin, epoxy resin and unsaturated polyester resin;
thermoplastic elastomers (TPE) such as olefin thermoplastic elastomer, styrene thermoplastic elastomer, polyester thermoplastic elastomer, urethane thermoplastic elastomer and amide thermoplastic elastomer; and
thermosetting elastomers such as rubbers.

The resin component may include a single kind of resin, or may include two or more kinds thereof.

The number of the resin component that configures the metal-resin complex (excluding a fragile portion when it is made of resin) may be one or two or more. When two or more resin components are used, each of the resin components may be joined with the metal component or at least one of the resin components may not be joined with the metal component.

For example, the metal resin complex may have a first resin component and a second resin component, wherein the first resin component is joined with the metal component and the second resin component is joined with the first resin component.

The method for joining the resin components is not particularly limited, and may be performed by fusing, or by means of an adhesive or a fastening means such as a screw. When two or more resin components are used in the metal-resin complex, the type of the resin included in the resin components may be the same or different from each other.

Exemplary configurations of the metal-resin complex having two or more resin components include a configuration having a metal component that configures one of the principal planes, a resin component that configures the other one of the principal planes, and another resin component that is disposed between metal component and the resin component as the principal planes and joins the same.

The resin component may include a component other than a resin.

Examples of the component other than a resin include a filler such as glass fiber, carbon fiber and inorganic powder, a thermal stabilizer, an antioxidant, a pigment, a weathering agent, a fire retardant, a plasticizer, a dispersant, a lubricant, a releasing agent and an antistat.

When the resin component includes a component other than a resin, the content of the resin with respect to the total mixture thereof is preferably 10% by mass or more, more preferably 20% by mass or more, further preferably 30% by mass or more.

### (Purpose of metal-resin complex)

The purpose of the metal-resin complex is not particularly limited. For example, the metal-resin complex is suitably used for cooling a heat-emitting body, such as CPUs for computers and secondary batteries for electric vehicles. In addition, the metal-resin complex is suitably used for various purposes that require temperature control, such as air conditioning systems, boiler systems and power-generation systems.

### <Cooling device>

The cooling device according to the present invention is a cooling device, comprising the metal-resin complex as described above, and a channel for a liquid to flow through that is disposed inside the space of the metal-resin complex.

The cooling device has a metal component and a resin component. Therefore, the cooling device is more adaptable to demand for complicated shape, weight reduction, production cost reduction and the like, as compared with a cooling device that is made of metal in its entirety.

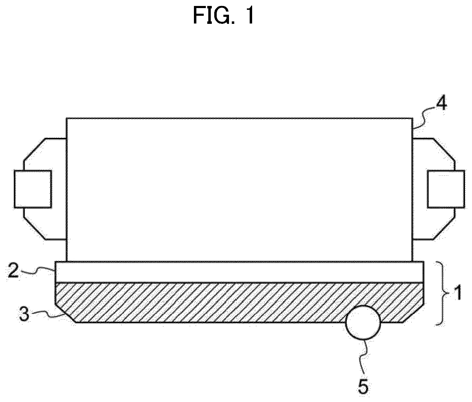

Fig. 1 illustrates an exemplary configuration of the cooling device in a state of cooling a heat-emitting body.

A cooling device 1 shown in Fig. 1 has a plate shape formed from a metal component 2 and a resin component 3, and cools a heat-emitting body 4 (for example, a secondary battery) disposed on the cooling device 1. A fragile portion 5 is disposed at the resin component 2. When an inner pressure of a space inside the cooling device 1 (not shown) exceeds a predetermined level, the fragile portion 5 is opened and the pressure in the space is reduced. As a result, occurrence of accidents such as separation of the metal component 2 from the resin component 3 at an interface thereof or scattering of a liquid flowing inside the space can be minimized.

The channel disposed inside the space may be a part of the metal component or the resin component that configures the cooling device.

Providing a channel as a part of the metal component has the advantage that a channel having an ability to dissipate heat, in addition to an ability to control the flowage, can be obtained.

Providing a channel as a part of the resin component has the advantage that a channel can be formed with a high degree of freedom in shaping, which enables the channel to perform highly-precise flowage control.

The cooling device may have at least one of a channel as a part of the metal component and a channel as a part of the resin component, or may have both of the same.

The cooling device may have a channel that is a different component from the metal component or the resin component that configures the cooling device.

The shape of the channel disposed inside the space is not particularly limited, and may be selected depending on the type of the heat-emitting body to be cooled, or the like.

For example, in a case of cooling a heat-emitting body that generates a greater amount of heat at a terminal than at a main body, the cooling device may have a channel such that a flow rate of a fluid is regulated to be greater at an edge portion than a central portion of the space. In that case, the cooling device can cool the edge portion of the space in an intensive manner, thereby cooling the heat-emitting body in an efficient manner.

In the present disclosure, the "edge portion of a space" refers to at least a portion of the periphery of a region corresponding to the space, or an adjacent area thereof, when a cooling device is observed from a direction perpendicular to a plane that contacts a heat-emitting body. The "central portion of a space" refers to a central portion of a region corresponding to the space, when a cooling device is observed from a direction perpendicular to a plane that contacts a heat-emitting body.

The cooling device may have an opening for introducing a fluid into the space and an opening for discharging a fluid from the space. The location of the openings are not particularly limited, and may be selected depending on the shape, purpose or the like of the cooling device.

At the opening, a joint component that connects an inside of the casing and an external pipe may be provided. The material for the joint component is not particularly limited, and may be metal or resin.

The cooling device may have a cover component that covers a heat-emitting body disposed on the cooling device. The material for the cover component is not particularly limited, and may be metal or resin.

### <Method for manufacturing metal-resin complex>

The method for manufacturing a metal-resin complex according to the present invention is a method for manufacturing the metal-resin complex as described above, wherein the resin component has a through hole that penetrates from an inside to an outside of the space, and the fragile portion is formed by fusing a resin that plugs the through hole with the resin component.

According to the method, it is possible to form a fragile portion that plugs a through hole disposed at the resin component. The method for fusing the fragile portion with the resin component is not particularly limited, and may be performed by a known process such as injection molding or laser fusing.

From the viewpoint of reducing a pressure by opening the fragile portion in an effective manner, the strength of fusion between the fragile portion and the resin component is preferably smaller than the strength of the components surrounding the space. The strength of fusion between the fragile portion and the resin component can be adjusted by selecting the type of resin that configures the resin component and the fragile portion, selecting the configuration of the fused portion, or the like.

### <Safety valve structure>

The safety valve structure according to the present invention is a safety valve structure, comprising:
a first resin component that configures at least a portion around a closed space;
a through hole formed at the first resin component; and
a second resin component that plugs the through hole,
the second resin component being fused with the first resin component and being openable in accordance with fluctuations in an inner pressure of the space.

In the safety valve structure, a pressure inside the space is reduced by opening the second resin component when the inner pressure in the closed space exceeds a predetermined level. In that way, it is possible to minimize the occurrence of breakage of the space in its entirety, scattering of the content of the space, and the like.

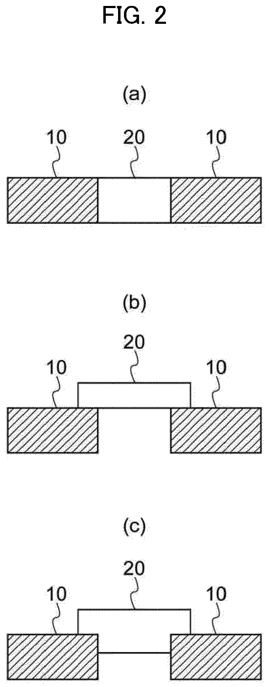

The configuration in which the first resin component and the second resin component are fused together is not particularly limited. Examples of the configuration include a configuration in which the second resin component 20 plugs the inside of the through hole disposed at the first resin component 10, as shown in Fig. 2 (a); a configuration in which the second resin component 20 plugs an inlet of the through hole disposed at the first resin component 10, as shown in Fig. 2 (b); and a configuration in which the second resin component 20 plugs a portion of the inside and an inlet of the through hole disposed at the first resin component 10, as shown in Fig. 2 (c).

The method for fusing the first resin component with the second resin component is not particularly limited, and may be performed by a known process such as injection molding or laser fusing.

The material for the first resin component and the second resin component is not particularly limited, and may be selected from the exemplary materials for the resin component as described above. The material for the first resin component may be the same or different from the material for the second resin component. From the viewpoint of ease of fusion, the material for the first resin component is preferably the same as the material for the second resin component.

The safety valve structure may configure a portion of the metal-resin complex as described above. Specifically, the first resin component and the second resin component may configure the resin component and the fragile portion of the metal-resin complex, respectively.

The disclosure of Japanese Patent Application No. 2020-103294 is incorporated herein by reference in its entirety.

All publications, patent applications, and technical standards mentioned in the present specification are incorporated herein by reference to the same extent as if each individual publication, patent application, or technical standard was specifically and individually indicated to be incorporated by reference.

## Claims

1. A metal-resin complex, comprising a space surrounded by a metal component and a resin component, the resin component comprising at least one fragile portion.

2. The metal-resin complex according to claim 1, wherein the metal component has a panel shape.

3. The metal-resin complex according to claim 1 or claim 2, wherein the fragile portion has a greater degree of stress concentration than a portion around the fragile portion.

4. The metal-resin complex according to claim 1 or claim 2, wherein the fragile portion has a lower strength than a portion around the fragile portion.

5. The metal-resin complex according to any one of claim 1 to claim 4, wherein a material of the fragile portion is identical with a material that forms a portion of the resin component other than the fragile portion.

6. The metal-resin complex according to any one of claim 1 to claim 5, wherein in the resin component, the fragile portion and a portion other than the fragile portion are fused together.

7. The metal-resin complex according to any one of claim 1 to claim 6, wherein in the resin component, the fragile portion has a smaller thickness than a portion other than the fragile portion.

8. The metal-resin complex according to any one of claim 1 to claim 7, wherein the metal component has a concave-convex structure at at least a portion of a surface of the metal component.

9. The metal-resin complex according to claim 8, wherein the resin component penetrates the concave-convex structure at the surface of the metal component.

10. The metal-resin complex according to claim 8, comprising an adhesive between the metal component and the resin component, the adhesive penetrating the concave-convex structure at the surface of the metal component.

11. A cooling device, comprising the metal-resin complex according to any one of claim 1 to claim 10, and a channel for a liquid to flow through that is disposed inside the space of the metal-resin complex.

12. A method for manufacturing the metal-resin complex according to any one of claim 1 to claim 11, wherein the resin component has a through hole that penetrates from an inside to an outside of the space, and the fragile portion is formed by fusing a resin that plugs the through hole with the resin component.

13. A safety valve structure, comprising:
a first resin component that configures at least a portion around a closed space;
a through hole formed at the first resin component; and
a second resin component that plugs the through hole,
the second resin component being fused with the first resin component, and being openable in accordance with fluctuations in an inner pressure of the space.
